**Europäisches Patentamt**

**European Patent Office**

**Office européen des brevets**

(19)

(11) Veröffentlichungsnummer: **0 281 684
B1**

(12)

# EUROPÄISCHE PATENTSCHRIFT

(45) Veröffentlichungstag der Patentschrift:
**12.12.90**

(21) Anmeldenummer: **87118980.9**

(22) Anmeldetag: **17.09.83**

(60) Veröffentlichungsnummer der früheren Anmeldung
nach Art. 76 EPÜ: **0107028**

(51) Int. Cl.⁵: **H03K 17/08**

(54) **Überspannungsgeschützter Darlingtonschalter.**

(30) Priorität: **21.10.82 DE 3238880**

(43) Veröffentlichungstag der Anmeldung:
**14.09.88 Patentblatt 88/37**

(45) Bekanntmachung des Hinweises auf die Patenterteilung:
**12.12.90 Patentblatt 90/50**

(84) Benannte Vertragsstaaten:
**DE FR GB**

(56) Entgegenhaltungen:
**US-A- 4 359 652**

**IEEE JOURNAL OF SOLID-STATE CIRCUITS, Band
SC-15, Nr. 3, Juni 1980, Seiten 277-281, IEEE, New York,
US; P. ANTOGNETTI et al.: "Three-dimensional
transient thermal simulation: application to delayed
short circuit protection in power IC's"
ELECTRONICS, Band 47, Nr. 3, 7. Februar 1974,
Seiten 119-123, New York, US; R.C. DOBKIN: "IC with
load protection simulates power transistor"**

(73) Patentinhaber: **ROBERT BOSCH GMBH, Postfach 50,
D-7000 Stuttgart 1(DE)**

(72) Erfinder: **Kalkhof, Bernd, Dipl.-Ing., Am Rosenbach 10,
D-7410 Reutlingen 28(DE)**
Erfinder: **Nagel, Karl, Grundstrasse 24,
D-7419 Gomaringen(DE)**

## Beschreibung

### Stand der Technik

Die Erfindung betrifft eine Schaltungsanordnung nach der Gattung des Patentanspruchs 1.

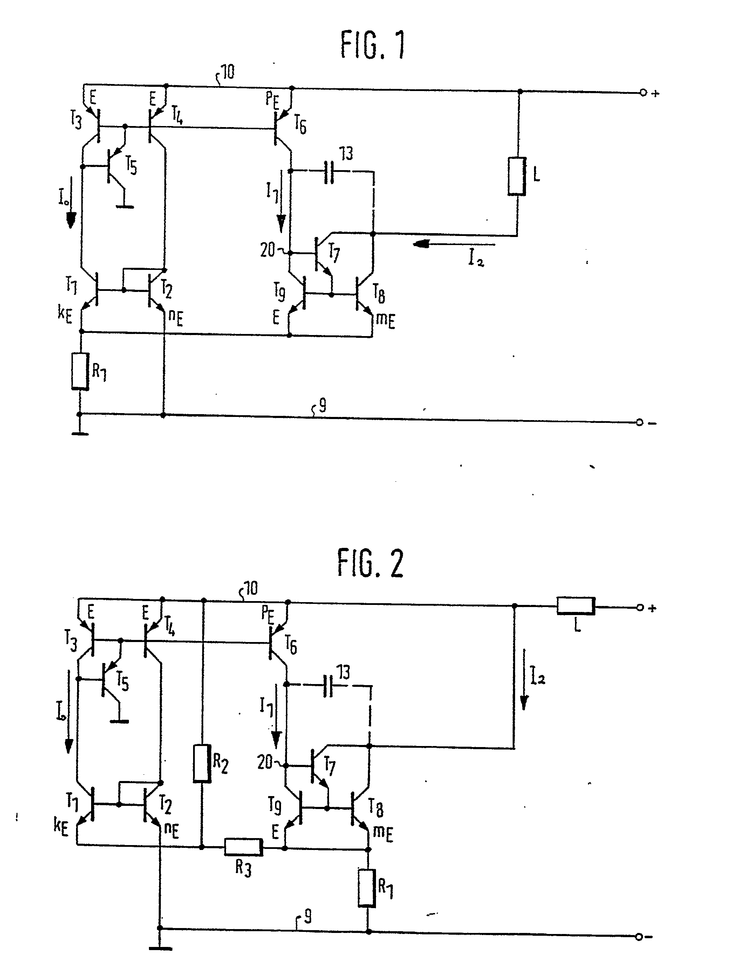

Aus dem Aufsatz R. C. Dobkin "IC with load protection simulates power transistor" aus der Zeitschrift Electronics, Band 47, Nr. 3 vom 7. Februar 1974, Figur 2, Seite 120 ist bereits eine Schaltungsanordnung dieser Art bekannt, bei der der mit einem Emitter mit dem als Regelstrecke dienenden ersten ohmschen Widerstand verbundene dritte Transistor noch einen zweiten Emitter hat, wobei dieser zweite Emitter an den Verbindungspunkt zwischen dem zweiten ohmschen Widerstand und der ersten Zenerdiode angeschlossen ist. Bei dieser bekannten Schaltungsanordnung ist eine zweite Zenerdiode zwischen den dritten ohmschen Widerstand und den Kollektor der als Darlingtonschaltung ausgebildeten Ausgangstransistorschaltung gelegt. Diese bekannte Schaltungsanordnung hat aber den Nachteil, daß, wenn die Kollektor-Emitter-Spannung des ersten Transistors der Ausgangstransistorschaltung höher als die Summe der Durchbruchsspannungen der beiden Zenerdioden ist, diese Spannung zwar durch den Durchbruch der beiden Zenerdioden begrenzt wird, der Ansteuerstrom der Ausgangstransistorschaltung diese aber nach wie vor in den leitenden Zustand steuert, so daß sie beim Auftreten von Überspannung nicht vor Beschädigung geschützt ist.

### Vorteile der Erfindung

Die erfindungsgemäße Schaltungsanordnung mit den kennzeichnenden Merkmalen des Patentanspruchs 1 hat demgegenüber den Vorteil, daß, wenn die Kollektor-Emitter-Spannung des ersten Transistors der Ausgangstransistorschaltung höher als die Summe der Durchbruchsspannungen der beiden Zenerdioden ist, der Ansteuerstrom der Ausgangstransistorschaltung zur negativen Bestriebsstromleitung abgeführt wird und damit die Augangstransistorschaltung gesperrt wird. Die genannte Kollektor-Emitter-Spannung kann nun weiter ansteigen, ohne daß die Ausgangstransistorschaltung durch Überlastung zerstört wird.

Weitere Vorteile ergeben sich aus den Unteransprüchen 2 bis 4.

### Zeichnung

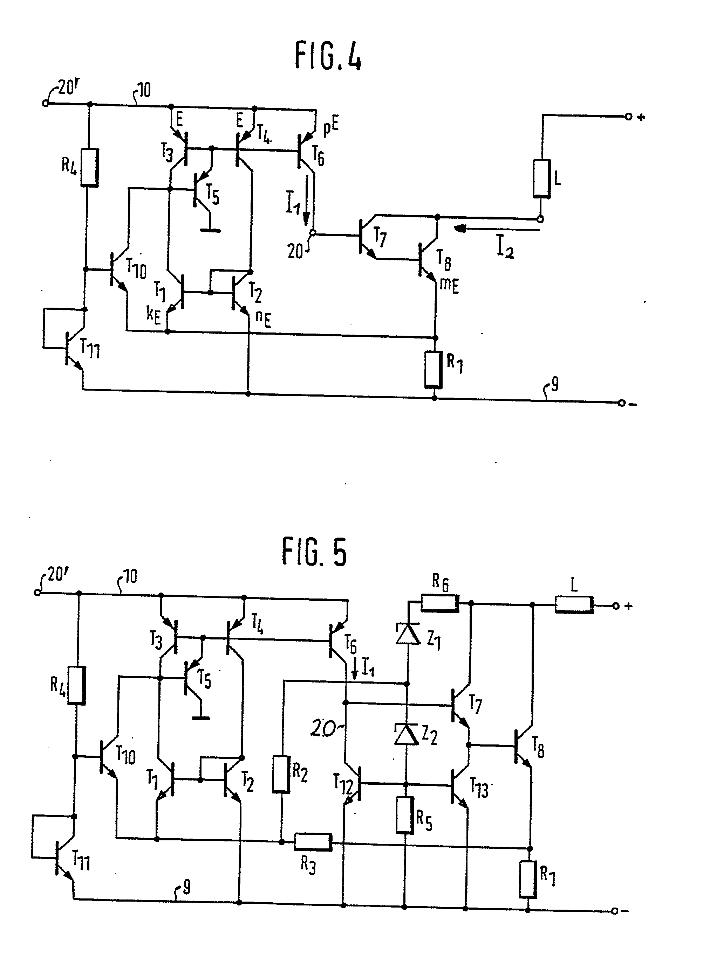

Fünf Schaltungsanordnungen sind in der Zeichnung dargestellt und in der nachfolgenden Beschreibung näher erläutert. Die Figuren 1 bis 4 zeigen je eine Schaltungsanordnung aus EP-A 0 107 028, der früheren Anmeldung nach Art. 76 EPÜ. Figur 5 zeigt ein Ausführungsbeispiel der erfindungsgemäßen Schaltungsanordnung.

In Figur 1 ist eine Schaltungsanordnung mit einer Ausgangstransistorschaltung dargestellt, die aus zwei npn-Transistoren $T_7$, $T_8$ besteht, die in Darlingtonschaltung miteinander verbunden sind. Der gemeinsame Kollektor der beiden Transistoren $T_7$, $T_8$ liegt an dem einen Ende einer Last L, deren anderes Ende an die Plusklemme einer Batterie angeschlossen ist. Der Emitter des ersten Transistors $T_8$ ist über einen ohmschen Widerstand $R_1$ mit der Minusklemme der Batterie verbunden. An einen Steueranschluß 20 der Ausgangstransistorschaltung $T_7$, $T_8$ ist eine in der Zeichnung nicht dargestellte Steuerschaltung gelegt, die beim normalen Betrieb der Schaltungsanordnung zur Ansteuerung der Ausgangstransistorschaltung $T_7$, $T_8$ dient.

Ferner bildet der zwischen dem Emitter des Transistors $T_8$ und der Minusklemme der Batterie liegende ohmsche Widerstand $R_1$ die Regelstrecke einer von der Versorgungsspannung unabhängigen, an sich bekannten, als Ringstromquelle ausgebildeten Bezugsstromquelle, die zwischen einer positiven Betriebsstromleitung 10 und einer negativen Betriebsstromleitung 9 angeordnet ist. Die positive Betriebsstromleitung 10 ist dabei an die Plusklemme der Batterie und die negative Betriebsstromleitung 9 an die Minusklemme der Batterie angeschlossen. Ferner wird der Auskoppelstrom $I_1$ der Bezugsstromquelle dem Steueranschluß 20 des Ausgangstransistors $T_7$, $T_8$ zugeführt. Eine Bezugsstromquelle dieser Art ist beispielsweise aus der Zeitschrift "Philips Technische Rundschau", 32. Jahrgang, 1971/72, Nr. 1, Seite 8, Abb. 10, bekannt.

Darüber hinaus ist ein npn-Transistor $T_9$ vorgesehen sein, dessen Emitter-Basis-Strecke parallel zur Emitter-Basis-Strecke des Transistors $T_8$ liegt und dessen Kollektor an die Basis 20 des Transistors $T_7$ angeschlossen ist. Der Transistor $T_9$ bildet zusammen mit den Transistoren $T_7$, $T_8$ eine Stromspiegelschaltung, deren Eingang durch den Kollektor des Transistors $T_9$ und deren Ausgang durch den Kollektor des Transistors $T_8$ gebildet wird, wobei der Vortransistor $T_7$ der Darlingtonschaltung als Basisstromverstärker des Stromspiegels wirkt. Die Emitterfläche des Transistors $T_9$ ist dabei mit E bezeichnet. Der Transistor $T_8$ kann eine von der Fläche E verschiedene Emitterfläche mE haben, wobei m vorzugsweise größer als Eins ist.

Die als Ringstromquelle ausgebildete Bezugsstromquelle besteht aus den Transistoren $T_1$, $T_2$, $T_3$, $T_4$, $T_5$, $T_6$, wobei die Transistoren $T_1$ und $T_2$ als npn-Transistoren und die Transistoren $T_3$, $T_4$, $T_5$, $T_6$ als pnp-Transistoren ausgebildet sind. Die Transistoren $T_1$ bis $T_6$ sind dabei wie im folgenden beschrieben zusam-

mengeschaltet: Der Transistor $T_3$ ist mit seinem Emitter an die positive Betriebsstromleitung 10 und mit seinem Kollektor an den Kollektor des Transistors $T_1$ angeschlossen, während seine Basis an die Basen der Transistoren $T_4$ und $T_6$ angeschlossen ist. Der Emitter des Transistors $T_3$ hat die Fläche E, der Emitter des Transistors $T_4$ ist an die Betriebsstromleitung 10, sein Kollektor an den Kollektor des Transistors $T_2$ angeschlossen. Der Transistor $T_4$ hat die Emitterfläche E. Die Basen der Transistoren $T_3$ und $T_4$ sind über die Emitter-Basis-Strecke des Transistors $T_5$ mit dem Kollektor des Transistors $T_3$ verbunden, wobei der Kollektor des Transistors $T_5$ an die negative Betriebsstromleitung 9 angeschlossen ist. Die Transistoren $T_3$, $T_4$, $T_5$ wirken dabei als Stromspiegel, wobei der Transistor $T_5$ als Basisstromverstärker dient. Der Emitter des Transistors $T_1$ hat die Emitterfläche kE und ist über den Widerstand $R_1$ an die negative Betriebsstromleitung 9 angeschlossen, während seine Basis an die Basis und an den Kollektor des Transistors $T_2$ angeschlossen ist. Der Emitter des Transistors $T_2$ hat die Fläche nE und ist an die negative Betriebsstromleitung 9 angeschlossen. Zur Bereitstellung des Auskoppelstroms $I_1$ der Bezugsstromquelle dient der Auskoppeltransistor $T_6$, dessen Emitter die Fläche pE hat und an die positive Betriebsstromleitung 10 angeschlossen ist, während der Kollektor des Transistors $T_6$ den Auskoppelstrom $I_1$ liefert und an den Steueranschluß 20 der Ausgangstransistorschaltung $T_7$, $T_8$ angeschlossen ist. Die beschriebene Ringstromquelle stellt eine vereinfachte Ausführungsform der obenerwähnten, aus der Zeitschrift "Philips Technische Rundschau" bekannten Stromquelle dar.

Darüber hinaus ist der Kollektor des Transistors $T_6$ über eine Kapazität 13 mit dem Kollektor des Transistors $T_8$ verbunden.

Wenn die Stromverstärkungen der pnp-Transistoren und der npn-Transistoren beide groß gegenüber Eins sind, dann erzwingt der aus den Transistoren $T_3$, $T_4$ und $T_5$ bestehende Stromspiegel Stromgleichheit. Es gilt dann für die Flußspannungen der Transistoren $T_1$ und $T_2$:

$$(1) \quad U_{BE1} = U_T \cdot \ln \frac{I_o}{k \cdot I_S} \quad \text{und}$$

$$(2) \quad U_{BE2} = U_T \cdot \ln \frac{I_o}{n \cdot I_S},$$

wobei $U_T = \frac{K}{q} T$ die Temperaturspannung, K die Boltzmannkonstante, q die Elementarladung, T die absolute Temperatur und $I_S$ der Sättigungsstrom ist. Der Spannungsabfall am Widerstand $R_1$ ist:

$$(3) \quad U_{R1} = R_1 \cdot (I_0 + I_1 + I_2).$$

Dabei ist

$$(4) \quad I_1 = m \cdot I_0 \qquad\qquad (5) \quad I_2 = p \cdot I_1$$

Der Spannungsumlauf an den Schaltungselementen $T_1$, $T_2$ und $R_1$ ergibt:

$$(6) \quad U_{R1} = U_{BE2} - U_{BE1}.$$

Durch Einsetzen der Werte aus den Gleichungen (1) bis (5) in Gleichung (6) erhält man:

$$(7) \quad I_2 = \frac{U_T}{R_1} \cdot \frac{1}{1 + \frac{1}{p} + \frac{1}{mp}} \cdot \ln \frac{k}{n}$$

Durch die anhand der Figur 1 beschriebenen Schaltungsmaßnahmen wird also der über die Emitter-Kollektor-Strecke des Transistors $T_8$ im Kurzschlußfall fließende Ausgangsstrom unter Einbeziehung des dritten Transistors $T_9$ auf den in Gleichung (7) angegebenen Wert begrenzt, wobei $U_T$, wie oben angegeben, die Temperaturspannung ist. In der Praxis werden m und p groß sein, um größere Ausgangsströme zu erreichen. Entfällt der dritte Transistor $T_9$, so geht p gegen unendlich. Damit wird aus Gleichung (7)

$$(7a) \quad I_2 = \frac{U_T}{R_1} \cdot \ln \frac{k}{n} \cdot$$

Die Temperaturspannung $U_T$ ist proportional zur absoluten Temperatur. Der Temperaturkoeffizient beträgt dabei + 3,3 ‰/K. Wählt man fér den Widerstand $R_1$ einen Widerstand mit demselben Temperaturkoeffizienten, so wird die Anordnung temperaturkompensiert. Günstiger ist noch, den Temperaturkoeffizienten des Widerstandes $R_1$ größer als den Temperaturkoeffizienten der Temperaturspannung $U_T$ zu wählen, um mit steigender Temperatur einen kleiner werdenden Ausgangsstrom, d.h. auch eine geringere Verlustleistung zu erhalten. Hier bietet sich ein Metallwiderstand mit einem Temperaturkoeffizienten von 3,9 ‰/K an.

Bei der Schaltung nach Figur 2 ist die positive Betriebsstromleitung 10 abweichend von der Schaltung nach Figur 1 an den Kollektor des Transistors $T_8$ angeschlossen, der seinerseits über die Last L mit der Plusklemme der Batterie verbunden ist. Die Bezugsstromquelle liegt wieder zwischen der positiven Betriebsstromleitung 10 und der negativen Betriebsstromleitung 9. Der Widerstand $R_1$ liegt zwischen dem Emitter des Transistors $T_8$ und der negativen Betriebsstromleitung 9. Die aneinander angeschlossenen Emitter der beiden Transistoren $T_8$ und $T_9$ sind über den Widerstand $R_3$ mit dem Emitter des Transistors $T_1$ verbunden, während vom Emitter des Transistors $T_1$ ein Widerstand $R_2$ zur positiven Betriebsstromleitung 10 führt. Durch die Einfügung der Widerstände $R_2$ und $R_3$ wird gegenüber der Schaltung nach Figur 1 eine Verkleinerung des durch die Last L fließenden Stroms in Abhängigkeit von der zwischen den beiden Betriebsstromleitungen 9 und 10 liegenden Spannung erreicht.

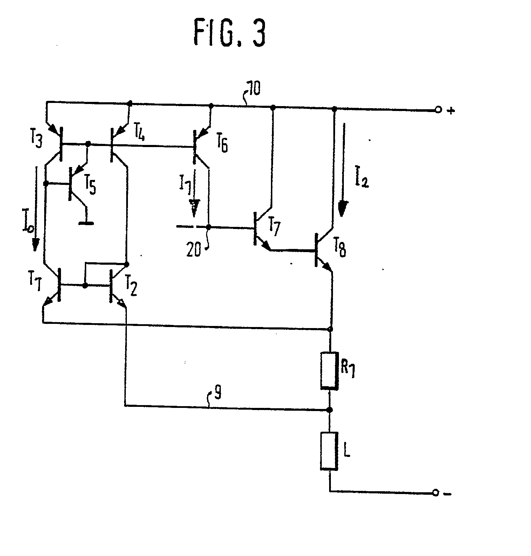

Figur 3 zeigt eine weitere Schaltungsanordnung. Der Aufbau entspricht weitgehend der Schaltungsanordnung nach den Figuren 1 und 2. Jedoch liegt die Last L in der Emitterzuleitung des Transistors $T_8$, während dessen Kollektor an der positiven Batterieklemme liegt, an die die positive Betriebsstromleitung 10 unmittelbar angeschlossen ist. Die Regelstrecke $R_1$ der Bezugsstromquelle liegt zwischen dem Emitter des Transistors $T_8$ und der Last L, wobei die negative Betriebsstromleitung 9 an die von der Regelstrecke $R_1$ zur Last L führende Verbindungsleitung angeschlossen ist.

Bei den Schaltungen nach den Figuren 4 und 5 ist im Gegensatz zu den Schaltungen nach den Figuren 1 bis 3 das Potential der ersten Betriebsstromleitung 1o der Bezugsstromquelle nicht von dem Potential der Plusklemme der Batterie abgeleitet. Vielmehr ist dort die Betriebsstromleitung 10 von der Plusklemme der Batterie abgetrennt und statt dessen an einen äußeren Anschluß 20' angeschlossen, der als Steueranschluß der gesamten Schaltungsanordnung dient und anstelle des Anschlusses 20 als "Basis" der Ausgangstransistorschaltung $T_7$, $T_8$ wirkt. Diesem Anschluß 20' wird bei diesen Schaltungsanordnungen das der Basis 20 der Ausgangstransistorschaltung $T_7$, $T_8$ zuzuführende, zur Ansteuerung diese Transistorschaltung dienende Steuersignal zugeführt. Die gesamte Schaltungsanordnung wirkt deshalb als modifizierter Darlingtontransistor.

Bei den Schaltungsanordnungen nach den Figuren 4 und 5 ist ferner jeweils eine zum Anlaufen der Bezugsstromquelle dienende Anlaufschaltung vorgesehen, die aus den Schaltelementen $T_{10}$, $T_{11}$ und $R_4$ besteht.

Das Ausführungsbeispiel nach Figur 5 enthält ferner zur Stromrückregelung die bereits beim Ausführungsbeispiel nach Figur 2 verwendeten Widerstände $R_2$, $R_3$.

Zur Überspannungsabschaltung sind bei diesem erfindungsgemäßen Ausführungsbeispiel ferner die Schaltelemente $R_6$, $Z_1$, $Z_2$, $R_5$, $T_{12}$ und $T_{13}$ vorgesehen.

Die Wirkungsweise dieses Schaltungsteils ist folgende:

Ist die Kollektor-Emitter-Spannung des Ausgangstransistors $T_7$, $T_8$ kleiner als die Durchbruchsspannung der Zenerdiode $Z_1$, so befindet sich die Schaltungsanordnung im Normalzustand, das heißt, der Strom wird auf den Wert

$$(7a) \quad I_2 = \frac{U_T}{R_1} \cdot \ln \frac{k}{n}$$

begrenzt. Liegt dagegen die Kollektor-Emitter-Spannung des Ausgangstransistors $T_7$, $T_8$ zwischen der Durchbruchsspannung der Zenerdiode $Z_1$ und der Summe der Durchbruchsspannungen der beiden Zenerdioden $Z_1$ und $Z_2$, so findet eine Rückregelung des Stromes gemäß der anliegenden Kollektor-Emitter-Spannung statt. Liegt schließlich die Kollektor-Emitter-Spannung des Ausgangstransistors $T_7$, $T_8$ höher als die Summe der Durchbruchsspannungen der beiden Zenerdioden $Z_1$ und $Z_2$, so werden die Transistoren $T_{12}$ und $T_{13}$ leitend, so daß der Ansteuerstrom vom Kollektor des Transisiors $T_6$ zur negativen Leitung 9 abgeführt wird, d.h. der Ausgangstransistor $T_7$, $T_8$ gesperrt wird. Die Kollektor-Emitter-Spannung kann nun weiter ansteigen, ohne daß der Ausgangstransistor $T_7$ $T_8$ durch Überlastung zerstört wird, aber es ist

$$(8) \quad U_{CE\,max} < U_{CBO}.$$

Der Widerstand $R_5$ hat die Aufgabe, Sperrströme der Transistoren $T_{12}$ und $T_{13}$ abzuleiten und die Zenerdioden $Z_1$ und $Z_2$ in einem definierten Arbeitspunkt zu betreiben. Durch entsprechende Wahl der Zenerspannungen kann die Überspannungsabschaltung bzw. der Einsatz der Rückregelung den verschiedenen Anwendungsfällen angepaßt werden.

**Patentansprüche**

1. Schaltungsanordnung mit einer mit ihrer Schaltstrecke in Reihe zu einer Last (L) und in Reihe zu einem ersten ohmschen Widerstand (R₁) liegenden Ausgangstransistorschaltung, bei der die äußeren Enden dieser Reihenschaltung mit einer ersten und einer zweiten Batterieklemme (+ bzw. -) verbunden sind, und mit einer zwischen einer ersten Betriebsstromleitung (10) und einer zweiten Betriebsstromleitung (9) angeordneten Bezugsstromquelle (T₁ bis T₆, R₁) mit einem von der Versorgungsspannung unabhängigen, einem Steueranschluß (20) der Ausgangstransistorschaltung zugeführten Auskoppelstrom (I₁) der durch den als Regelstrecke dienenden ersten ohmschen Widerstand (R₁) einstellbar ist, wobei die Ausgangstransistorschaltung einen ersten Transistor (T₈) und einen zweiten Transistor (T₇) vom gleichen Leitungstyp wie der erste Transistor (T₈) enthält, der Kollektor des zweiten Transistors (T₇) an den Kollektor des ersten Transistors (T₈) und der Emitter des zweiten Transistors (T₇) an die Basis des ersten Transistors (T₈) angeschlossen ist und die Basis des zweiten Transistors (T₇) einen Steueranschluß (20) der Ausgangstransistorschaltung bildet, wobei ferner ein dritter Transistor (T₁) vorgesehen ist, der Bestandteil der Bezugsstromquelle (T₁ bis T₆, R₁) ist, den gleichen Leistungstyp wie die beiden genannten Transistoren (T₇, T₈) der Ausgangsransistorschaltung hat und mit einem Emitter mit dem als Regelstrecke dienenden ersten ohmschen Widerstand (R₁) verbunden ist, an dem genannten Emitter des dritten Transistors (T₁) ein zweiter ohmscher Widerstand (R₂) liegt, der mit seinem anderen Anschluß über eine erste Zenerdiode (Z₁) und einen dritten ohmschen Widerstand (R₆) in der genannten Reihenfolge mit der ersten Batterieklemme (+) verbunden ist und wobei schließlich die Anode der ersten Zenerdiode (Z₁) am zweiten ohmschen Widerstand (R₂) liegt, dadurch gekennzeichnet, daß zwischen den genannten Emitter des dritten Transistors (T₁) und den als Regelstrecke dienenden ersten ohmschen Widerstand (R₁) ein vierter ohmscher Widerstand (R₃) geschaltet ist, daß zwischen die zweite Betriebsstromleitung (9) und die Anode der ersten Zenerdiode (Z₁) die Reihenschaltung aus einem fünften ohmschen Widerstand (R₅) und einer zweiten Zenerdiode (Z₂) in der genannten Reihenfolge gelegt ist, wobei die beiden Zenerdioden (Z₁, Z₂) gleichsinnig zueinander in Reihe geschaltet sind, daß an die Anode der zweiten Zenerdiode (Z₂) jeweils die Basis eines vierten Transistors (T₁₂) und eines fünften Transistors (T₁₃) vom Leitungstyp des ersten (T₈) und des zweiten Transistors (T₇) angeschlossen ist, wobei die Emitter dieser beiden Transistoren (T₁₂, T₁₃) jeweils an die zweite Betriebsstromleitung (9) angeschlossen sind, der Kollektor des vierten Transistors (T₁₂) an die Basis des zweiten Transistors (T₇) und der Kollektor des fünften Transistors (T₁₃) an die Basis des ersten Transistors (T₈) angeschlossen ist.

2. Schaltungsanordnung nach Anspruch 1, dadurch gekennzeichnet, daß zwischen den Steueranschluß (20) und den gemeinsamen Kollektor der als Darlingtonschaltung ausgebildeten Ausgangstransistorschaltung (T₇, T₈) ein Kondensator (13) gelegt ist.

3. Schaltungsanordnung nach Anspruch 1 oder 2, dadurch gekennzeichnet, daß die erste Betriebsstromleitung (10) mit der ersten Batterieklemme (+) und die zweite Betriebsstromleitung (9) mit der zweiten Batterieklemme (-) verbunden ist.

4. Schaltungsanordnung nach Anspruch 1 oder 2, dadurch gekennzeichnet, daß das Potential der ersten Betriebsstromleitung (10) durch das einem Steueranschluß (20') der Schaltungsanordnung zuführbare Steuerpotential gebildet wird, das über die Bezugsstromquelle (T₁ bis T₆, R₁) in den Steueranschluß (20) der Ausgangstransistorschaltung (T₇, T₈) einkoppelbar ist, und daß die zweite Betriebsstromleitung (9) mit der zweiten Batterieklemme (-) verbunden ist.

**Revendications**

1. Circuit comportant un circuit de sortie à transistors dont le chemin de commutation est en série une charge (L) et en série sur une première résistance ohmique (R₁), les bornes extérieures de ce montage en série étant reliées à une première et à une seconde borne de batterie (+ , −) et une source de courant de référence (T₁ ... T₆, R₁) branchée entre une première ligne de courant de fonctionnement (10) et une seconde ligne de courant de fonctionnement (9), source fournissant un courant de découplage (I₁) indépendant de la tension d'alimentation et qui est appliqué à une borne de commande (20) du circuit de sortie à transistors, ce courant étant réglé par la première résistance ohmique (R₁) servant de chemin de réglage, le circuit à transistors de sortie ayant un premier transistor (T₈) et un second transistor (T₇) de même type de conduction que le premier transistor (T₈), le collecteur du second transistor (T₇) étant relié au collecteur du premier transistor (T₈) et l'émetteur du second transistor (T₇) étant relié à la base du premier transistor (T₇), la base du second transistor (T₇) formant une borne de commande (20) pour le circuit de sortie à transistors, un troisième transistor (T₁) étant prévu qui fait partie de la source de courant de référence (T₁ ... T₆, R₁), ayant le même type de conduction que les deux transistors (T₇, T₈) ci-dessus du circuit de sortie et un émetteur auquel est reliée la première résistance ohmique (R₁) formant le chemin de régulation, cet émetteur du troisième transistor (T₁) étant relié à une seconde résistance ohmique (R₂) qui est reliée par son autre borne, par une première diode Zener (Z₁) et une troisième résistance ohmique (R₆) dans l'ordre ci-dessus avec la première borne (+) de la batterie et enfin l'anode de la première diode Zener (Z₁) est reliée à la seconde résistance ohmique (R₂), circuit caractérisé en ce qu'entre l'émetteur du troisième transistor (T₁) et la première résistance ohmique (R₁) servant de chemin de régulation, il est prévu une quatrième résistance ohmique (R3) montée entre la seconde ligne de courant de fonctionnement (9) et l'anode de la première diode Zener (Z1) avec le montage en série formé d'une cinquième résistance ohmique (R5) et d'une seconde diode Zener (Z2) dans l'ordre mentionné, les deux diodes Zener (Z1, Z2) étant montées en série dans le même sens et en ce que l'anode de la seconde diode Zener (Z2) est respectivement reliée à la base d'un quatrième transistor (T12) et d'un cinquième transistor (T13) du même type de conduction que le premier transistor (T8) et le second transistor (T7), l'émetteur de ces deux transistors (T12, T13) étant relié respectivement à la seconde ligne de courant de fonctionnement (9), le collecteur du quatrième transistor (T12) étant relié à la base du second transistor (T7) et le collecteur du cinquième transistor (T13) étant relié à la base du premier transistor (T8).

2. Circuit selon la revendication 1, caractérisé par un condensateur (13) branché entre la borne de commande (20) et le collecteur commun du circuit de sortie à transistors (T7, T8) branchés en montage Darlington.

3. Circuit selon la revendication 1 ou 2, caractérisé en ce que la première ligne de courant de fonctionnement (10) est reliée à la première borne de batterie (+) et la seconde ligne de courant de fonctionnement (9) est reliée à la seconde borne de batterie (–).

4. Circuit selon la revendication 1 ou 2, caractérisé en ce que le potentiel de la première ligne de fonctionnement (10) est formé par un potentiel de commande qui est appliqué à une borne de commande (20′) du circuit, ce potentiel de commande pouvant être couplé par la source de courant de référence (T1 ... T6, R1) à la borne de commande (20) du circuit de sortie à transistors (T7, T8) et en ce que la seconde ligne de courant de fonctionnement (9) est reliée à la seconde borne de batterie (–).

**Claims**

1. Circuit arrangement with an output transistor circuit, the switching path of which is connected in series with a load (L) and in series with a first ohmic resistance (R1), in which the outer ends of this series circuit are connected to a first and to a second battery terminal (+ and –, respectively), and with a reference current source (T1 to T6, R1) arranged between a first operating current line (10) and a second operating current line (9), with an output current (I1) which is independent of the supply voltage and is supplied to a control connection (20) of the output resistor circuit and which can be adjusted by the first ohmic resistance (Rl) which is used as controlled member, the output transistor circuit containing a first transistor (T8), and a second transistor (T7) of the same type of conduction as the first transistor (T8), the collector of the second transistor (T7) being connected to the collector of the first transistor (T8) and the emitter of the second transistor (T7) being connected to the base of the first transistor (T8) and the base of the second transistor (T7) forming a control connection (20) of the output transistor circuit, in which arrangement furthermore a third transistor (T1) is provided which is a component of the reference current source (T1 to T6, R1), has the same the of conduction as the two said transistors (T7, T8) of the output transistor circuit and is connected with an emitter to the first ohmic resistance (R1) used as controlled member, the said emitter of the third transistor (T1) being connected to a second ohmic resistance (R2) which is connected with its other connection via a first Zener diode (Z1) and a third ohmic resistance (R6) in the said order to the first battery terminal (+) and, finally, the anode of the first Zener diode (Z1) being connected to the second ohmic resistance (R2), characterized in that between the said emitter of the third transistor (T1) and the first ohmic resistance (R1) used as controlled member, a fourth ohmic resistance (R3) is connected, in that between the second operating current line (9) and the anode of the first Zener diode (Z1) the series circuit of a fifth ohmic resistance (R5) and of a second Zener diode (Z2) is connected in the said order, the two Zener diodes (Z1, Z2) being connected in series with one another in the same direction, in that the anode of the second Zener diode (Z2) is in each case connected to the base of a fourth transistor (T12) and of a fifth transistor (T13) of the type of conduction of the first (T8) and of the second transistor (T7), the emitters of these two transistors (T12, T13) in each case being connected to the second operating current line (9), the collector of the fourth transistor (T12) being connected to the base of the second transistor (T7) and the collector of the fifth transistor (T13) being connected to the base of the first transistor (T8).

2. Circuit arrangement according to Claim 1, characterized in that a capacitor (13) is placed between the control connection (20) and the common collector of the output transistor circuit (T7, T8) which is constructed as Darlington circuit.

3. Circuit arrangement according to Claim 1 or 2, characterized in that the first operating current line (10) is connected to the first battery terminal (+) and the second operating current line (9) is connected to the second battery terminal (–).

4. Circuit arrangement according to Claim 1 or 2, characterized in that the potential of the first operating current line (10) is formed by the control potential, which can be supplied to a control connection (20′) of the circuit arrangement and which can be coupled into the control connection (20) of the output transistor circuit (T7, T8) via the reference current source (T1 to T6, R1), and in that the second operating current line (9) is connected to the second battery terminal (–).

# FIG. 1

# FIG. 2

# FIG. 3

# FIG.4

# FIG. 5